(19) Europäisches Patentamt
European Patent Office
Office européen des brevets

(11) EP 0 799 279 B1

(12) EUROPEAN PATENT SPECIFICATION

(45) Date of publication and mention of the grant of the patent:
**28.03.2001 Bulletin 2001/13**

(21) Application number: **95941957.3**

(22) Date of filing: **12.12.1995**

(51) Int Cl.7: **C08L 67/06**, C08J 5/04, C08J 5/24

(86) International application number:
**PCT/SE95/01491**

(87) International publication number:
**WO 96/19537 (27.06.1996 Gazette 1996/29)**

(54) **Moulded Article**

Formkörper

Objet moulé

(84) Designated Contracting States:
**AT BE CH DE DK ES FR GB GR IE IT LI LU MC NL PT SE**

(30) Priority: **21.12.1994 SE 9404440**

(43) Date of publication of application:
**08.10.1997 Bulletin 1997/41**

(73) Proprietor: **PERSTORP AB**
**284 80 Perstorp (SE)**

(72) Inventors:
- **SÖRENSEN, Kent**
  **S-284 35 Perstorp (SE)**
- **PETTERSSON, Bo**
  **S-252 45 Helsingborg (SE)**
- **BOOGH, Louis**
  **CH-1023 Crissier (CH)**
- **MANSSON, Jan-Anders, Edvin**
  **CH-1812 Rivaz (CH)**

(74) Representative:
**Hansen, Bernd, Dr. Dipl.-Chem. et al**
**Hoffmann Eitle,**
**Patent- und Rechtsanwälte,**
**Arabellastrasse 4**
**81925 München (DE)**

(56) References cited:
**WO-A-93/17060** **WO-A-93/18079**

Remarks:
The file contains technical information submitted after the application was filed and not included in this specification

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 799 279 B1

## Description

The present invention relates to a moulded article with improved physical properties obtained by moulding and curing or partially curing a resin composition comprising at least two thermosetting resins and optionally in addition thereto at least one curing agent, catalyst, inhibitor or stabiliser. In a further aspect, the invention relates to the use of an at least partially chain terminated dendritic or hyperbranched polyester macromolecule in such moulded articles.

Hyperbranched and dendritic macromolecules (dendrimers) can generally be described as three dimensional highly branched molecules having a tree-like structure. Dendrimers are highly symmetric, while similar macromolecules designated as hyperbranched may to a certain degree hold an asymmetry, yet maintaining the highly branched tree-like structure. Dendrimers can be said to be monodisperse variations of hyperbranched macromolecules. Hyperbranched and dendritic macromolecules normally consist of an initiator or nucleus having one or more reactive sites and a number of branching layers of chain extending molecules and optionally a layer of one or more chain terminating molecules. The layers are usually called generations. Dendritic polyesters and processes to synthesise them are known from WO 93/18079 and 93/17060, respectively.

Composite materials can be classified in many ways depending on the identified concept. Generally can, however, a composite be classified as a material deriving its properties from two or more components which can be distinguished readily when examined in optical or electron microscopes. The strength and toughness of for instance engineering plastics are achieved by combining high strength phases such as various fibres or particles constituting a reinforcement and a ductile phase such as a resin or a resin composition constituting a matrix.

Composites are used in a wide variety of applications, each requiring specific properties from included components. The versatility of material property design and processing possibilities with thermosetting composite materials have been and will remain a major driving force for the use thereof. However, certain drawbacks still remain. Among these are some properties related to the mechanical anisotropy and often relatively high processing costs. The mechanical properties are mainly influenced by the properties, such as the toughness, of the resin matrix. Some important applications areas of thermosetting composites and the main requirements for further mechanical improvements can be listed as in below summary.

| TYPE OF PRODUCT | PROPERTIES IN NEED OF IMPROVEMENT |
|---|---|
| Aeronautic goods and articles | Impact properties, damage tolerance |
| Nautic goods and articles | Moisture absorption, impact |
| Chemicals/chemical goods and articles | Chemical resistance, notch sensitivity |
| Automotive goods and articles | Low velocity impact, fatigue tolerance |
| Sporting goods and articles | Fatigue, impact, low velocity impact |
| Leisure/commodity goods and articles | Damage tolerance, low velocity impact |
| Electric/electronic goods and articles | Thermal shock resistance |

The matrix toughness is one of the most important intrinsic properties of a thermosetting material, such as a composite, controlling various observable damages and failure mechanisms. Important mechanical properties and failure mechanisms can be summarised:

- The fatigue properties are controlled by the rate of crack growth through the material dependent of the inherent toughness and durability of the matrix and interfaces.
- The impact properties are characterised by the energy absorbed, the damage area and the residual strength after impact. Matrix toughness limits the extent of damage within the matrix thus allowing good residual strength.
- The low velocity impact property is the resistance to small impacts due to mishandling, such as dropping and stone hitting (important in automotive applications). The extent of damage is mainly controlled by the matrix toughness and adhesive properties.
- The damage tolerance and notch sensitivity are related to the presence of defects. These can originate from low velocity impacts, machining or production defaults. The further cracking of a composite material will involve a matrix cracking by traverse cracking (predominantly in 90° oriented plies) and delamination. Toughness is thus a major controlling parameter.

The matrix toughness is also important in controlling the edge effects of composite parts and the thermal loading inducing delamination. The prolongation of delamination induces matrix and possibly interfacial failures.

The plastic strain to failure can be increased by reduction of the crosslink density or the use of plasticisers. This, however, will very strongly affect the modulus and thermal properties of the material, only giving a moderate

increase in toughness. The toughness can effectively be increased by addition of a second phase, such as particles. The effect of particle toughening will regardless of the particle nature, for instance stiffness and thermal transition temperature, depend on the particle size, interparticle distance and volume fraction. Suitable particles for toughening are for instance glass particles, rubber particles and thermoplastic particles having either a rigid core and a soft shell or a soft core and a rigid shell structure. These particles can have different adhesive properties to the surrounding resin matrix affecting their toughening effect and influencing the modulus of the matrix. Toughening systems also include phase separation during curing. A dispersed spherical phase is usually created in such a process. Today commonly used toughening agents are for example rubber, carboxyl terminated butadiene acrylonitrile (CTBN rubber), latex and short reactive thermoplastic chains such as polyetherimides. CTBN rubber is the most effective and most widely used toughening agent. However, it very strongly affects the thermal and mechanical properties of the resin matrix. A combination of CTBN rubber and glass particles reduces the negative effect on the mechanical properties. Polyetherimide modifiers are most recently developed systems. These systems do not affect the thermal and mechanical properties of the matrix, but are less effective as toughening agents.

Processing techniques for reinforced composites often involve a wetting stage of a reinforcing bed. The wetting is most often done using a resin in liquid state thus requiring a controlled viscosity. The viscosity should be low in order to obtain a good penetration of for instance a fibre bed, a proper wetting of the fibres and a reduced wetting time. Modified matrices generally exhibit an increased viscosity and particles are often too large to be able to freely penetrate the reinforcing bed. As a consequence, in processing techniques producing superior quality composites or allowing products having a complex geometry to be produced at high productivity rates, particles will be subject to segregation, percolation or shear field segregation. The effect of the toughening agent will therefore strongly be reduced and can even become a source of weak spots if they agglomerate to a large extent. This kind of processing include prepreging and/or impregnation techniques, such as infusion, compression transfer, vacuum moulding, transfer moulding, injection moulding, gas assisted injection moulding, structural injection moulding, filament winding, resin immersion or resin infusion. Further processing techniques include die forming such as extrusion, rotary moulding, gravity moulding and blow moulding. Thus, the quality of the impregnation will decrease and processing times increase and even the quality of the final product may decrease. This is of course very much dependent on the particle size and to a lesser extent the particle volume fraction. The toughening effect of smaller particles is not optimal. Larger particles can be applied using an interleaf layer between plies of a composite material. This will increase the toughness of the interlamilar region where delamination occurs, but will not increase the toughness within the plies. CTBN rubber strongly increases the resin viscosity thus limiting the volume fraction that can be used.

It is an object of the present invention to provide a moulded article with improved physical properties, and according to a special aspect having increased toughness properties without, or only slightly affecting processability, thermal and other mechanical properties, as well as the use of dendromers. These objects are accomplished by the moulded articles and the use of dendritic or hyperbranched polyester macromolecules in accordance with Claims 1-16 of the present invention. The resin matrix is based on conventional thermosetting resins combined with functionalised dendritic or hyperbranched macromolecules of polyester type. As can be seen from Table 1 and the test results of Example 25, the toughening properties of these macromolecules are excellent and most important, toughening can be obtained without impairing the matrix modulus or the thermal properties.

Dendritic or hyperbranched macromolecules exhibit a spherical structure resembling that of particles. There is, however, no singularity in mechanical properties at the interface of the macromolecules and surrounding matrix as with various particles. Isolated macromolecules have in the case of phase separation, residual miscibility in the matrix, which due to the relatively high molecular weight, the unique molecular structure and large number of reactive sites will increases the toughness of the matrix. Increased matrix toughness is also seen in homogeneous matrices containing dendritic or hyperbranched macromolecules due to impacting forces being effectively distributed within the hyperbranched structure of said macromolecules. Dendritic and hyperbranched macromolecules do not or only moderately increase the viscosity and are of a small diameter despite the relatively high molecular weight. The macromolecules do not as for instance pre-shaped particles impart the processability of the system. The obtained toughening effect in a thermosetting material, such as a composite, will contrary to the interleaf technique be distributed homogeneously in all levels of the material.

The functionality and polarity of dendritic or hyperbranched macromolecules can be adapted to any resin system to provide appropriate reactive sites and phase separation properties. The macromolecules are therefore not as sensitive, to different matrix chemistry as for instance polyetherimide modifiers requiring a modification of the entire matrix chemistry. The relatively high molecular weight of the dendritic or hyperbranched macromolecules, used in accordance with the present invention, makes the control of the phase separation easier.

The moulded article according to the present invention includes at least two thermosetting resins or compounds. At least one of these compounds is a chain terminated dendritic or hyperbranched macromolecule of polyester type having at least one reactive site obtained through chain termination and at least one compound is a conventional thermosetting resin or aliphatic, cycloaliphatic or aromatic compound being monomeric or polymeric. The dendritic or

hyperbranched macromolecule has a chain termination providing at least one primary or secondary reactive site and the conventional resin or compound is selected from the group consisting of:

i) a monomeric or polymeric epoxide,
ii) a rubber modified monomeric or polymeric epoxide
iii) a saturated or unsaturated ester,
iv) a saturated or unsaturated polyester,
v) a hydroxyfunctional saturated or unsaturated ester,
vi) a hydroxyfunctional saturated or unsaturated polyester,
vii) a polyamine or a polyamide
viii) a bismaleimide,
ix) a phenol-formaldehyde resin,
x) a phenolic amino resin,
xi) a polyimide or polyetherimide,
xii) a melamine-formaldehyde resin,
xiii) a urea-formaldehyde resin,
xiv) an isocyanate and
xv) a urethane or a polyurethane having any of the functional groups -OH, -COOH or - NCO,

The resin composition, which in addition to said thermosetting resins optionally comprises at least one curing agent, catalyst, inhibitor or stabiliser, is moulded and cured or partially cured to provide the moulded article in accordance with the present invention

The chain terminated dendritic or hyperbranched macromolecule included in the resin composition is composed of a monomeric or polymeric nucleus having at least one reactive epoxide or hydroxyl group to which 1-100, preferably 1-20, generations of at least one monomeric or polymeric chain extender, whereby at least one generation includes at least one chain extender having at least two reactive hydroxyl groups and at least one reactive carboxyl group, are added. The yielded dendritic or hyperbranched macromolecule have substantially hydroxyl groups as terminal functions. The macromolecule is wholly or partly chain terminated by addition of at least one monomeric or polymeric chain stopper and/or by means of addition, oxidation, epoxidation, allylation, etherification or substitution, thereby providing the primary or secondary reactive sites.

The dendritic or hyperbranched macromolecule included in the thermosetting resin composition as well as in the moulded article is in different embodiments through the chain termination provided with at least one primary or secondary epoxide group, alkenyl group, amino group and/or anhydride group. The chain termination is preferably performed by means of at least one chain stopper selected from the group consisting of:

i) an unsaturated monofunctional carboxylic acid or, where applicable, an anhydride thereof,
ii) an unsaturated fatty acid,
iii) a glycidyl ester of a monofunctional carboxylic or fatty acid with 1-24 carbon atoms,
iv) a glycidyl ether of a monofunctional alcohol with 1-24 carbon atoms,
v) a carboxyfunctional unsaturated ester of a di, tri or polyfunctional carboxylic acid or, where applicable, an anhydride thereof, and
vi) an adduct between at least one mono, di, tri or polyhydroxysubstituted allyl ether and at least one mono, di, tri or polyfunctional carboxylic acid, or is performed by means of a compound such as an epihalohydrin, preferably epichlorohydrin, or an allylhalide, preferably allylchloride and/or allylbromide. A primary or secondary anhydride group is obtained by Michael addition of at least one unsaturated anhydride, such as maleic anhydride, to an unsaturation within the macromolecule and/or its chain termination. Michael addition is a base catalysed addition of carbanions to activated unsaturated systems.

The nucleus of said dendritic or hyperbranched macromolecule is in preferred embodiments of the present invention selected from the group consisting of

i) a mono, di, tri or polyfunctional alcohol, such as 5-ethyl-1,3-dioxane-5-methanol, 1,3-dioxane-5,5-dimethanol, neopentyl glycol, 2-ethyl-2-butyl- 1,3-propanediol, cyclohexane-1,4-dimethanol, trimethylolpropane, trimethylolethane, ditrimethylolpropane, ditrimethylolethane, pentaerythritol, dipentaerythritol, tripentaerythritol, sorbitol or reaction products thereof with ethylene oxide, propylene oxide, butylene oxide and/or phenylethylene oxide (styrene oxide),
ii) a mono, di, tri or polyfunctional epoxide, such as a glycidyl ester of a monofunctional carboxylic acid with 1-24 carbon atoms or a glycidyl ether of a monofunctional alcohol with 1-24 carbon atoms,

iii) a mono, di or triglycidyl substituted isocyanurate,
iv) a glycidyl ether of a condensation product between at least one phenol and at least one aldehyde or ketone or an oligomer of such a condensation product,
v) a glycidyl ether of a mono, di, tri or polyfunctional alcohol or a glycidyl ether of a reaction product of any of said alcohols and ethylene oxide, propylene oxide, butylene oxide and/or phenylethylene oxide (styrene oxide).

The chain extender used in these preferred embodiments is a dihydroxyfunctional monocarboxylic acid, such as 2,2-dimethylolpropionic acid.

The conventional resin included in the moulded article is in various embodiments an epoxide of formula

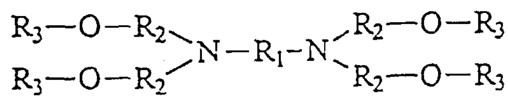

wherein
$R_1$ is cycloalkanyl, branched cycloalkanyl, aryl, branched aryl, linear or branched alkanylaryl; $R_2$ independently is linear or branched alkanyl, alkenyl or alkynyl; and wherein $R_3$ independently is H or

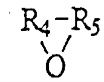

wherein
$R_4$ is CH or $C_2$ - $C_{10}$ linear or branched alkanyl, alkenyl or alkynyl and $R_5$ is $CH_2$ or $C_2$ - $C_{10}$ linear or branched alkanyl, alkenyl or alkynyl, whereby at least one substituent $R_3$ is

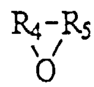

The conventional resin can alternatively be an epoxide of formula

$$R_3 - O - R_2 - R_1 - R_2 - O - R_3$$

wherein
$R_1$ is cycloalkanyl, branched cycloalkanyl, aryl, branched aryl, linear or branched alkanylaryl; $R_2$ independently is NH, linear or branched alkanyl, alkenyl or alkynyl and wherein $R_3$ independently is H or

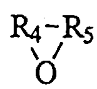

wherein
$R_4$ is CH or $C_2$ - $C_{10}$ linear or branched alkanyl, alkenyl or alkynyl and $R_5$ is $CH_2$ or $C_2$ - $C_{10}$ linear or branched alkanyl, alkenyl or alkynyl, whereby at least one substituent $R_3$ is

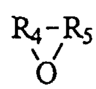

The conventional resin is in preferred embodiments of the invention selected from the group consisting of

i) an epoxide, such as a glycidyl ether, of a condensation product between at least one phenol and at least one aldehyde or ketone or an oligomer of such a condensation product or

ii) an unsaturated ester or polyester having maleate, vinyl and/or allyl unsaturation.

The suitable weight ratio between dendritic or hyperbranched macromolecule provided with primary reactive, dendritic or hyperbranched macromolecule provided with secondary reactive sites and conventional resin is found within the weight ratio of 1:99 to 30:70, preferably 5:95 to 25:75.

The moulded article is in certain embodiments according to the present invention a decorative or an industrial laminate, which may contain at least one sheet or web of paper or glass fibre as reinforcement and/or base material.

The surface of moulded article can, in specific applications of embodiments of the present invention, be metal plated or metal clad, such as copper clad laminates for printed circuits and aeronautical parts.

The moulded article according to the present invention is in preferred embodiments a composite containing fibres in the form of a web, a cloth, a sheet, threads or cut fibres as reinforcement material. The fibres are preferably selected among glass fibres, carbon fibres, aramide fibres and organic fibres.

The moulded article can in further embodiments of the present invention be a so called prepreg in the form of a roll, a sheet, a web or a cloth obtained by impregnation with the thermosetting resin composition, according to the present invention, followed by a partially curing of the resin to a so called B-stage.

The moulded article according to the invention can advantageously be used in the production of goods and articles within aeronautical, nautical, chemical, automotive, sporting, leisure and commodity as well as for applications within the electric and electronic industry.

A process for production of a moulded article according to the invention can be characterised in that the article is obtained by moulding a thermosetting resin composition as disclosed above, which resin composition is cured. This can in certain embodiments be obtained in that two or more prepregs in the form of a sheet, a web, a cloth, threads or cut fibres of glass fibre, carbon fibre, aramide fibre, organic fibres such as cellulose impregnated with the thermosetting composition and partially cured to a so called B-stage are laminated together under heat and/or pressure.

Various embodiments of a process for production of a moulded article according to the invention include:

- that glass fibres, carbon fibres, aramide fibres, organic fibres, such as cellulose, or the like are pre-shaped to a bed which is then impregnated with a resin composition by infusion, compression transfer, injection or the like, whereupon the resin is cured;
- that a bundle, tow, tape or the like of glass fibres, carbon fibres, aramide fibres, organic fibres or the like is impregnated with a resin composition whereupon said bundle, tow or tape after an optional drying is wound on a core to form a structural part, followed by curing of the resin;
- that glass fibres, carbon fibres, aramide fibres, organic fibres or the like are impregnated with a resin composition which is added to a mould, the mould being rotated to form the moulded article by means of polar gravity force;
- that the moulded article is obtained by spraying a resin composition onto or into a pre-shaped mould whereupon the resin is cured; and
- that a moulded article product is obtained by injection moulding or compression moulding.

Disclosed and other objects and the attendant advantages will be more fully understood from enclosed embodiment Examples 1-25 and enclosed Table 1, wherein:

- Examples 1 and 2 relate to preparation of hyperbranched macromolecules.
- Examples 3-8, 22 and 24 relate to chain termination of the hyperbranched macromolecules of Examples 1 and 2. The chain termination provides the macromolecules with primary or secondary reactive sites.
- Examples 9-15 relate to preparation of thermosetting resin compositions wherein macromolecules from Examples 3-8 are included.
- Example 16 is a comparative example wherein a thermosetting resin composition outside the scope of the invention is prepared.
- Example 17 relates to preparation of moulded specimens based on the thermosetting compositions of Examples 9-16.
- Examples 18-21 relate to evaluations of moulded specimens prepared in Example 17.
- Example 23 relates to preparation of a polymeric chain stopper used in Example 24 to provide the product of Example 22 with alkenyl groups in form of allyl unsaturation.
- Example 25 relates to preparation and evaluation of an unsaturated resin composition comprising the product of Example 24.

Table 1 presents results obtained in Examples 18-21 with moulded materials based on resin compositions

according to Examples 9-16.

While particular embodiments of the invention are shown in the embodiment Examples, it will be understood, of course, that the invention is not limited thereto since many modifications may be made, and it is, therefore, contemplated to cover by the appended Claims any such modifications as fall within the scope of the said claims.

## Example 1

A hyperbranched polyester of 2 generations was prepared from an ethoxylated pentaerythritol and 2,2-dimethylolpropionic acid.

308.9 g (0.85 mole) of pentaerythritol pentaethoxylate (Polyol PP 50, Perstorp Polyols, Sweden), 460.5 g (3.42 moles) of 2,2-dimethylolpropionic acid (Bis-MPA, Perstorp Polyols, Sweden) and 0.46 g (0.004 mole) of $H_2SO_4$ (96%-w/w) were charged in a 4-necked reaction flask equipped with stirrer, pressure gauge, cooler and receiver. The temperature was raised to 120°C, at which temperature 2,2-dimethylolpropionic acid began to melt and esterification water was formed. The temperature was thereafter during 20 minutes raised to 140°C, giving a transparent solution, whereby a vacuum of 30-50 mm Hg was applied. The reaction was, under stirring, allowed to continue for 4 hours, after which time the acid value was determined to be 7.0 mg KOH/g. 460.5 g (6.84 moles) of 2,2-dimethylolpropionic acid and 0.7 g (0.007 mole) of $H_2SO_4$ (96%-w/w) were now during 15 minutes added to the reaction mixture. A vacuum of 30-50 mm Hg was applied when charged 2,2-dimethylolpropionic acid was dissolved. The reaction was now allowed to continue for a further 4 hours giving a final acid value of ≈ 10 mg KOH/g.

Obtained product exhibited the following properties:

| | |
|---|---|
| Acid value, mg KOH/g | 10.2 |
| Hydroxyl value, mg KOH/g | 500 |
| Theoretical hydroxyl value, mg KOH/g | 511 |
| Molecular weight, g/mole | 1824 |
| Theoretical molecular weight, g/mole | 1748 |

## Example 2

A hyperbranched polyester of 3 generations was prepared by adding a third generation to the product of Example 1.

600.0 g of the hyperbranched polyester according to Example 1, 717.0 g (5.35 moles) of 2,2-dimethylolpropionic acid and 0.7 g (0.007 mole) of $H_2SO_4$ (96%-w/w) were charged in a 4-necked reaction flask equipped with stirrer, pressure gauge, cooler and receiver. The temperature was raised to 120°C, at which temperature 2,2-dimethylolpropionic acid began to melt and esterification water was formed. The temperature was thereafter during 20 minutes raised to 140°C, giving a transparent solution, whereby a vacuum of 30-50 mm Hg was applied. The reaction was now under stirring allowed to continue for 5 hours giving a final acid value of ≈ 10 mg KOH/g.

Obtained product exhibited the following properties:

| | |
|---|---|
| Acid value, mg KOH/g | 10.6 |
| Hydroxyl value, mg KOH/g | 493 |
| Theoretical hydroxyl value, mg KOH/g | 498 |
| Molecular weight, g/mole | 3311 |
| Theoretical molecular weight, g/mole | 3608 |

## Example 3

A chain stopped hyperbranched polyester was produced from the product of Example 2 and oleic acid.

251.2 g of the hyperbranched polyester according to Example 2, 592.3 g of oleic acid, 1.0 g of an inorganic catalyst (Fascat® 4100, Atochem, the Netherlands), 0.5 g of $Ca(OH)_2$ and 55 g of xylene were charged in a 4-necked reaction flask equipped with stirrer, nitrogen inlet, cooler and water trap (Dean-Stark).

The temperature was during 65 minutes raised to 220°C, at which temperature reaction water was formed. The reaction was now allowed to continue until an acid value of < 9 mg KOH/g was reached. The reaction time at 220°C was 420 minutes. The polyester was finally filtered using a small amount of a filter aid (Celite) to remove residual catalysts and formed calcium soaps.

Obtained product exhibited the following properties:

| | |
|---|---|
| Theoretical molecular weight, g/mole | 11600 |
| Final acid value, mg KOH/g | 8.2 |
| Hydroxyl value, mg KOH/g | 8.0 |
| Viscosity, 23°C, mPas | 3090 |
| Non-volatile content, % | 100.0 |

**Example 4**

A chain stopped hyperbranched polyester was produced from the product of Example 2 and oleic acid.
Example 3 was repeated with the differences:

- that 455.8 g of oleic acid were charged instead of 592.3 g and
- that the reaction at 220°C was allowed to continue until an acid value of < 5 mg KOH/g was reached. The reaction time at 220°C was 300 minutes.

Obtained product exhibited the following properties.

| | |
|---|---|
| Theoretical molecular weight, g/mole | 9900 |
| Final acid value, mg KOH/g | 4.7 |
| Hydroxyl value, mg KOH/g | 37.0 |
| Viscosity, 23°C, mPas | 7520 |
| Non-volatile content, % | 99.8 |

**Example 5**

An epoxidised (chain terminated) hyperbranched polyester was produced from the product of Example 1 and epichlorohydrin.
100.0 g of the hyperbranched polyester according to Example 1 was charged in a 4-necked reaction flask equipped with stirrer, nitrogen inlet, cooler and water-trap (Dean-Stark). The temperature was raised to 130°C at which temperature 0.6 g $BF_3$ etherate was added to the reaction mixture. 195.0 g (2.11 moles) of epichlorohydrin was then during 30 minutes added at a rate sufficiently low to suppress observed exothermic reaction. The reaction was allowed to continue at 130°C for 80 minutes, after which time the temperature was decreased to 100°C and 100 ml of toluene and 100 ml of 1,4-dioxane were added. 38.7 g (0.97 mole) of NaOH was now during 60 minutes added whereupon the solution became opaque and reaction water was formed. The reaction was allowed to continue for a further 120 minutes and the reaction mixture was thereafter cooled and passed through a pressurised filter to remove precipitated NaCl. Remaining solvents and epichlorohydrin were thereafter removed by means of a rotary evaporator.
Obtained product exhibited the following properties:

| | |
|---|---|
| Theoretical molecular weight, g/mole | 2644 |
| Epoxy equivalent weight (EEW-value), g/equivalent | 285 |
| Theoretical EEW-value, g/equivalent | 165 |
| Hydrolysable chlorine content, % | 0.6 |
| Viscosity, 23°C, mPas | 21400 |
| Non-volatile content, % | 99 7 |

**Example 6**

An epoxidised (chain terminated) hyperbranched polyester was produced from the product of Example 2 and epichlorohydrin
Example 5 was repeated with the differences:

- that 100.0 g of the hyperbranched polyester according to Example 2 were charged instead of the hyperbranched polyester according to Example 1 and
- that the reaction time at 130°C was 120 minutes instead of 80 minutes.

Obtained product exhibited the following properties:

| | |
|---|---|
| Theoretical molecular weight, g/mole | 5400 |
| Epoxy equivalent weight (EEW-value), g/equivalent | 311 |
| Theoretical EEW-value, g/equivalent | 169 |
| Hydrolysable chlorine content, % | 0.9 |

## Example 7

An epoxidised (chain terminated) hyperbranched polyester with secondary epoxide groups was produced from obtained product according to Example 3 and *m*-chloroperbenzoic acid.

26.36 g of *m*-chloroperbenzoic acid and 750 ml of dichloromethane were at room temperature charged in a 3-necked reaction flask equipped with stirrer, nitrogen inlet and cooler. Obtained solution was cooled to 0°C and 38.86 g of the product according to Example 3 dissolved in 250 ml of dichloromethane were now during 60 minutes instilled. Resulting reaction mixture was at 0°C stirred during 120 minutes followed by precipitation of excess *m*-chloroperbenzoic acid. The reaction mixture was now allowed to react at room temperature for a further 18 hours. Resulting product was thereafter purified by extraction using 3 x 250 ml of 0.1 M aqueous $Na_2S_2O_3$ followed by 3 x 250 ml of saturated aqueous $NaHCO_3$. The mixture was allowed to phase separate and the organic layer was removed. The final product was thereafter recovered by removal of solvent under full vacuum at 50°C using a rotary evaporator.

Obtained product exhibited the following properties

| | |
|---|---|
| Epoxy equivalent weight (EEW-value), g/equivalent | 440 |
| Theoretical EEW-value, g/equivalent | 384 |
| Viscosity, 23°C, mPas | 7000 |
| Non-volatile content, % | 100.0 |

## Example 8

An epoxidised (chain terminated) hyperbranched polyester with secondary epoxide groups was produced from obtained product according to Example 4 and *m*-chloroperbenzoic acid.

26.36 g of m-chloroperbenzoic acid and 1500 ml of dichloromethane were at room temperature charged in a 3-necked reaction flask equipped with stirrer, nitrogen inlet and cooler. Obtained solution was cooled to 0°C and 100.0 g of the product according to Example 4 dissolved in 800 ml of dichloromethane were now during 120 minutes instilled. Resulting reaction mixture was at 0° stirred during 120 minutes followed by precipitation of excess *m*-chloroperbenzoic acid. The reaction mixture was now allowed to react at room temperature for a further 16.5 hours. Resulting product was thereafter purified by extraction using 3 x 700 ml of 0.1 M aqueous $Na_2S_2O_3$ followed by 2 x 250 ml of saturated aqueous $NaHCO_3$. The mixture was allowed to phase separate and the organic layer was removed. The final product was thereafter recovered by removal of solvent under full vacuum at 50°C using a rotary evaporator.

Obtained product exhibited the following properties:

| | |
|---|---|
| Epoxy equivalent weight (EEW-value), g/equivalent | 436 |
| Theoretical EEW-value, g/equivalent | 429 |
| Viscosity, 23°C, mPas | 30000 |
| Non-volatile content, % | 100.0 |

## Example 9

A thermosetting resin composition was prepared by mixing the product according to Example 5 with a commercial epoxide of bisphenol-F type (Araldite®, LY 5082, Ciba-Geigy, Switzerland) having a functionality of 2 and a commercial isophorone diamine curing agent (Hardener HY 5083, Ciba-Geigy, Switzerland) having a functionality of 4 The components were mixed at 23°C using mechanical stirring for 5 minutes. The resin was subsequently degassed at 23°C in a vacuum chamber at 0.1 bar for 10 minutes.

The resin composition had the following formulation and properties:

| | |
|---|---|
| Product according to Example 5, g | 25.0 |

(continued)

| | |
|---|---|
| Commercial epoxide, g | 75.0 |
| Curing agent, g | 21.3 |
| | |
| Amine:epoxide (molar ratio) | 1:1 |
| Non-volatile content, % | 100.0 |
| Viscosity at 25°C, mPas | 800 |

**Example 10**

Example 9 was repeated with the difference that the product according to Example 5 was replaced by the product according to Example 6.

The resin composition had the following formulation and properties:

| | |
|---|---|
| Product according to Example 6, g | 25.0 |
| Commercial epoxide, g | 75.0 |
| Curing agent, g | 20.6 |
| | |
| Amine:epoxide (molar ratio) | 1:1 |
| Non-volatile content, % | 100.0 |
| Viscosity at 25°C, mPas | 900 |

**Example 11**

Example 9 was repeated with the difference that the product according to Example 5 was replaced by a substantially reduced percentage of the product according to Example 7.

The resin composition had the following formulation and properties.

| | |
|---|---|
| Product according to Example 7, g | 1.0 |
| Commercial epoxide, g | 99.0 |
| Curing agent, g | 22.7 |
| Amine:epoxide (molar ratio) | 1:1 |
| Non-volatile content, % | 100.0 |
| Viscosity at 25°C, mPas | 600 |

**Example 12**

Example 9 was repeated with the difference that the product according to Example 5 was replaced by a reduced percentage of the product according to Example 7.

The resin composition had the following formulation and properties:

| | |
|---|---|
| Product according to Example 7, g | 5.0 |
| Commercial epoxide, g | 95.0 |
| Curing agent, g | 22.6 |
| | |
| Amine:epoxide (molar ratio) | 1:1 |
| Non-volatile content, % | 100.0 |
| Viscosity at 25°C, mPas | 700 |

**Example 13**

Example 9 was repeated with the difference that the product according to Example 5 was replaced by the product according to Example 8.

The resin composition had the following formulation and properties:

| | |
|---|---|
| Product according to Example 8, g | 5.0 |
| Commercial epoxide, g | 95.0 |
| Curing agent, g | 22.3 |
| | |
| Amine:epoxide (molar ratio) | 1:1 |
| Non-volatile content, % | 100.0 |
| Viscosity at 25°C, mPas | 600 |

**Example 14**

Example 9 was repeated with the difference that the product according to Example 5 was replaced by a reduced percentage of the product according to Example 8.

The resin composition had the following formulation and properties:

| | |
|---|---|
| Product according to Example 8, g | 15.0 |
| Commercial epoxide, g | 85.0 |
| Curing agent, g | 21.0 |
| | |
| Amine:epoxide (molar ratio) | 1:1 |
| Non-volatile content, % | 100.0 |
| Viscosity at 25°C, mPas | 1100 |

**Example 15**

Example 9 was repeated with the difference that the product according to Example 5 was replaced by a combination of the products according to Examples 5 and 8.

The resin composition had the following formulation and properties:

| | |
|---|---|
| Product according to Example 5, g | 25.0 |
| Product according to Example 8, g | 5.0 |
| Commercial epoxide, g | 70.0 |
| Curing agent, g | 20.7 |
| | |
| Amine:epoxide (molar ratio) | 1:1 |
| Non-volatile content, % | 100.0 |
| Viscosity at 25°C, mPas | 900 |

**Example 16** (Comparative Example)

A thermosetting resin composition was prepared by mixing a commercial epoxide of bisphenol-F type (Araldite® LY 5082, Ciba-Geigy, Switzerland) having a functionality of 2 with a commercial isophorone diamine curing agent (Hardener HY 5083, Ciba-Geigy, Switzerland) having a functionality of 4. The components were mixed at 23°C using mechanical stirring for 5 minutes. The resin was subsequently degassed at 23°C in a vacuum chamber at 0.1 bar for 10 minutes.

The resin composition had the following formulation and properties:

| | |
|---|---|
| Commercial epoxide, g | 100.0 |
| Curing agent, g | 23.0 |
| | |
| Amine:epoxide (molar ratio) | 1:1 |
| Non-volatile content, % | 100 0 |
| Viscosity at 25°C, mPas | 600 |

**Example 17**

Thermosetting resin compositions according to examples 9-16 were at 23°C poured into steel moulds having the internal dimensions 110 x 27 x 2.5 mm and 27 x 25 x 10 mm, respectively. The moulds were pre-treated with a silicone based mould release agent. The resin compositions were cured in the moulds, resulting in moulded plastic specimens having dimensions equal to the internal dimensions of the moulds. Curing was performed in an oven with circulating air.

| | | |
|---|---|---|
| **Schedule** | Heating | 23 - 80°C, gradient 3°C/minute |
| | Curing | 80°C during 900 minutes |
| | Cooling | 80- 23°C, gradient 6°C/minute |

**Example 18**

Samples were cut out from the plastic specimens produced from resin compositions of Examples 9-11, 13 and 15-16, which resin compositions were moulded and cured in 110 x 27 x 2.5 mm moulds in accordance with Example 17. Cutting was made by a rotating saw blade and the edges of the samples were polished with a 240 grid sand paper and rinsed with demineralised water. The samples were subsequently dried and aged at 23°C in air for at least 7 days. Chips were using a razor blade prior to testing cut from the samples.
The Glasstransition Temperatures (Tg) were recorded by means of a Perkins-Elmer DSC7 (Differential Scanning Colorimeter) apparatus using the following parameters:

| | |
|---|---|
| Average sample weight, mg | 20 |
| Temperature range, °C | 0 - 130 |
| Heating gradient, °C/minute | 10 |
| Cooling gradient, °C/minute | 150 |
| Stabilisation time at 0°C, minute | 5 |
| Heating gradient, °C/minute | 10 |

Obtained results are given in Table 1.

**Example 19**

Samples having the dimensions 100 x 12 x 2.5 mm were cut from the plastic specimens produced from the resin compositions of Examples 9-16, which resin compositions were moulded and cured in 110 x 27 x 2.5 mm mould in accordance with Example 17. Cutting was made by a rotating saw blade and the edges of the samples were polished with a 400 grid sand paper.
The Tensile Modulus (E) were recorded by means of a Zwick Screw tensile testing apparatus equipped with an extensometer.
The following parameters were used:

| | |
|---|---|
| Extensometer gauge length, mm | 35 |
| Length between grips, mm | 70 |
| Crosshead rate, mm/minute | 2 |

Obtained results are given in Table 1.

**Example 20**

Samples were, using a rotary saw blade, cut from the plastic specimens produced from the resin compositions of Examples 9-16, which resin compositions were moulded and cured in 27 x 25 x 10 mm moulds in accordance with Example 17.
The samples were cut to the exterior dimensions 25 x 25 x 10 mm and machined for Compact Tension tests according to ASTM E399.
Critical Stress Intensity Factors ($K_{1c}$) according to ASTM E399 were recorded on a Zwick Screw tensile testing apparatus using a crosshead rate of 0.5 mm/min. Obtained results are given in Table 1.

**Example 21**

The Fracture Energy ($G_{1c}$) were determined from the results obtained in examples 19 and 20 according to the following equation:

$$G_{1c} = \frac{K_{1c}^2}{E}\left(1 - \upsilon^2\right)$$

wherein

$G_{1c}$ = Fracture Energy ($J/m^2$)
$K_{1c}$ = Critical Stress Intensity Factor ($MPa.m^{1/2}$)
E = Tensile Modulus (GPa)
$\upsilon$ = Poisson Ratio

Obtained results are given in Table 1.

**Example 22**

A chain stopped hyperbranched polyester was produced from the product of Example 1 and caprylic/capric acid.

830.0 g of the of the hyperbranched polyester according to Example 1, 677.7 g (4.59 moles) of a mixture of caprylic and capric acid, 2.0 g (0 03 mole) of $Ca(OH)_2$ and 75 g of xylene were charged in a 4-necked reaction flask equipped with stirrer, nitrogen inlet, cooler and water trap (Dean-Stark). The reaction mixture was during 50 minutes heated to 170°C, whereby esterification water began to evaporate. The temperature was now during 120 minutes raised from 170°C to 210°C, giving a temperature gradient of 0 3°C/minute. The esterification was allowed to continue under stirring for 510 minutes until an acid value of < 6 mg KOH/g was obtained. Xylene was thereafter removed by a 20 minutes vacuum evaporation.

Obtained product exhibited the following properties:

| | |
|---|---|
| Final acid value, mg KOH/g | 4.2 |
| Hydroxyl value, mg KOH/g | 111 |
| Viscosity, 23°C, mPas | 127 |
| Non-volatile content, % | 99.3 |

**Example 23**

A carboxyfunctional chain stopper was prepared from trimethylolpropane diallyl ether and succinic anhydride.

502.2 g (3.20 moles) of trimethylolpropane diallyl ether (TMPDE-80, Perstorp Polyols, Sweden) and 207 g (2.07 moles) of succinic anhydride were charged in a 4-necked reaction flask equipped with a magnetic stirrer, nitrogen inlet and a cooler. The reaction mixture was during 120 minutes heated to 130°C and kept at this temperature for a further 120 minutes. Obtained product was thereafter cooled to room temperature.

Obtained product exhibited the following properties:

| | |
|---|---|
| Acid value, mg KOH/g | 368 |
| Hydroxyl value, mg KOH/g | 390 |
| Viscosity, 23°C, mPas | 46 |

**Example 24**

An unsaturated polyester was prepared from the products of Example 22 and Example 23.

400.0 g of the product according to Example 22, 180.0 g of the product according to Example 23, 1.4 g of $H_2SO_4$ (96%-w/w) and 48 g of heptane were charged in a 4-necked reaction flask equipped with stirrer, nitrogen inlet,

cooler and water trap (Dean-Stark). The reaction mixture was during 30 minutes heated to 120°C, whereby esterification water began to evaporate. The esterification was allowed to continue at 120°C for 390 minutes until an acid value of ≈ 8 mg KOH/g was obtained. The product was now neutralised with 3.0 g of $Ca(OH)_2$. Heptane was removed by a 20 minutes vacuum evaporation and the product was finally filtered to remove excess $Ca(OH)_2$ and formed calcium compounds.

Obtained product exhibited the following properties:

| | |
|---|---|
| Final acid value, mg KOH/g | 4.9 |
| Viscosity, 23°C, mPas | 13800 |
| Non-volatile content, % | 127 |

**Example 25**

An unsaturated resin composition was prepared by mixing the product according to Example 24 with a commercial unsaturated polyester (Norpol® 20-00, Jotun A/S, Norway) and adding cobalt octoate and methyl ethyl ketone (MEK) peroxide. The components were mixed at 23°C using mechanical stirring for 5 minutes.

The resin composition was compared to said commercial polyester with said addition of cobalt octoate and MEK peroxide.

| **Resin Compositions** | Composition 1 (Exampel 24) | Composition 2 (Comparative) |
|---|---|---|
| Commercial polyester, g | 95.0 | 100.0 |
| Product according to Example 24, g: | 5.0 | --- |
| Cobalt octoate (12% Co), g: | 1.0 | 1.0 |
| MEK peroxide, g: | 1.0 | 1.0 |

The resin compositions (Compositions 1 and 2) were moulded and cured in 27 x 25 x 10 mm and 110 x 27 x 2.5 mm moulds

**Curing schedule**

23°C - 20 minutes
80°C - 160 minutes

**i)** Samples were, using a rotary saw blade, cut from specimens cured in 27 x 25 x 10 mm moulds. The samples were cut to the exterior dimensions 25 x 25 x 10 mm and machined for Compact Tension tests according to ASTM E399. Critical Stress Intensity Factors ($K_{1c}$) according to ASTM E399 were recorded on a Zwick Screw tensile testing apparatus using a crosshead rate of 0.5 mm/minutes.

**ii)** Samples having the dimensions 100 x 12 x 2.5 mm were cut from the specimens cured in 110 x 27 x 2.5 mm moulds. Cutting was made by a rotating saw blade and sample edges were polished with a 400 grid sand paper. The Tensile Modulus (E) were recorded by means of a Zwick Screw tensile testing apparatus equipped with an extensometer.

The following parameters were used:

| | |
|---|---|
| Extensometer gauge length, mm | 35 |
| Length between grips, mm | 70 |
| Crosshead rate, mm/minute | 2 |

| **Test Result** | | |
|---|---|---|
| Composition 1 (Example 24) | $K_{1c}$ = 0.98 MPa.m$^{1/2}$ | E = 2.9 GPa |
| Composition 2 (Comparative) | $K_{1c}$ = 0.62 MPa.m$^{1/2}$ | E = 2.5 GPa |

TABLE 1

| Results obtained in Examples 18 - 21. | | | | | | | | |
|---|---|---|---|---|---|---|---|---|
| **Moulded Material Based on Resin from Example** | **9** | **10** | **11** | **12** | **13** | **14** | **15** | **Comp. Ex. 16** |
| Tg, °C | 64 | 67 | 85 | 85 | 86 | 85 | 68 | 84 |
| E, GPa | 3.1 | 2.9 | 3.1 | 2.9 | 3.9 | 2.4 | 2.8 | 3.0 |
| $K_{1c}$, $MPa.m^{½}$ | 0.83 | 1.37 | 0.79 | 1.34 | 1.47 | 2.03 | 1.58 | 0.63 |
| $G_{1c}$, $J/m^2$ | 0.20 | 0.57 | 0.18 | 0.55 | 0.63 | 1.52 | 0.79 | 0.11 |
| Tg = Glasstransition Temperature<br>E = Tensile Modulus<br>$K_{1c}$ = Critical Stress Intensity Factor<br>$G_{1c}$ = Fracture Energy | | | | | | | | |

Table 1 and the test result of Example 25 show that moulded materials obtained by using a thermosetting composition according to the invention (Examples 9-15 and Composition 1 of Example 25) have a very high degree of toughening compared to the unmodified thermosetting composition (Example 16 and Composition 2 of Example 25). Materials exhibiting the highest value for the Tensile Modulus (E) together with the highest value for the Critical Stress Intensity Factor ($K_{1c}$) is considered to be the product with the best properties. The thermosetting compositions according to Examples 13 and 14 gave for example by far the best result among evaluated epoxides and Composition 1 of Example 25 gave an excellent result.

## Claims

**1.** A moulded article with improved physical properties obtained by moulding and curing or partially curing a resin composition comprising at least two thermosetting resins and optionally in addition thereto at least one curing agent, catalyst, inhibitor or stabiliser, characterised in that at least one of said thermosetting resins is an at least partially chain terminated dendritic or hyperbranched polyester macromolecule having at least one primary or secondary reactive site, that at least one is a conventional thermosetting resin selected from the group consisting of a polyepoxide, a rubber modified polyepoxide, a saturated or unsaturated polyester, a hydroxyfunctional saturated or unsaturated polyester, a polyamine or a polyamide, a phenol-formaldehyde resin, a phenolic amino resin, a polyimide or polyetherimide, a melamine-formaldehyde resin, a urea-formaldehyde resin, a polyurethane having any of the functional groups -OH, -COOH or -NCO, and that said dendritic or hyperbranched macromolecule and said conventional resin is present in a weight ratio of 1:99 to 30:70.

**2.** A moulded article according to claim 1 characterised in that said reactive site is a primary or secondary epoxide group.

**3.** A moulded article according to claim 1 characterised in that said reactive site is a primary or secondary amino group.

**4.** A moulded article according to claim 1 characterised in that said reactive site is a primary or secondary alkenyl group.

**5.** A moulded article according to claim 1 characterised in that said reactive site is a primary or secondary anhydride group.

**6.** A moulded article according to any of the claims 1-5 characterised in that it in addition to said resin composition comprises at least one filler, pigment or lubricant.

**7.** A moulded article according to any of the claims 1-6 characterised in that it comprises fibres as reinforcement material.

**8.** A moulded article according to claim 7 characterised in that said fibres are selected from the group consisting of glass fibres, carbon fibres, aramide fibres and organic fibres, such as cellulose.

**9.** A moulded article according to any of the claims 1-8 characterised in that said article is obtained by a continuous die forming procedure, such as injection moulding, compression moulding, rotary moulding, gravity moulding, blow moulding or extrusion.

**10.** A moulded article according to any of the claims 1-8 characterised in that said article is obtained by means of a processing technique selected from the group consisting of resin immersion or infusion, compression transfer, vacuum moulding, transfer moulding, injection moulding, gas assisted injection moulding, structural injection moulding, filament winding, extrusion, rotary moulding, gravity moulding and blow moulding.

**11.** A moulded article according to any of the claims 1-10 characterised in that said article is a so called prepreg obtained by a partial curing to a so called B-stage of a roll, a sheet, a web, a cloth, threads or cuttings impregnated with the thermosetting resin composition.

**12.** A moulded article according to any of the claims 1-10 characterised in that said article is a decorative or industrial laminate.

**13.** A moulded article according to claim 12 characterised in that said laminate is obtained by curing at least one prepreg.

**14.** A moulded article according to any of the claims 1-10 characterised in that said article is a semifinished or finished product selected from the group consisting of aeronautic goods and articles, nautic goods and articles, chemicals and chemical goods and articles, automotive goods and articles, sporting goods and articles, leisure and commodity goods and articles, and electric and electronic goods and articles.

**15.** The use of an at least partially chain terminated dendritic or hyperbranched polyester macromolecule having at least one primary or secondary reactive site, together with at least one conventional thermosetting resin selected from the group consisting of a polyepoxide, a rubber modified polyepoxide, a saturated or unsaturated polyester, a hydroxyfunctional saturated or unsaturated polyester, a polyamine or a polyamide, a phenol-formaldehyde resin, a phenolic amino resin, a polyimide or polyetherimide, a melamine-formaldehyde resin, a urea-formaldehyde resin, a polyurethane having any of the functional groups, -OH, -COOH or -NCO, whereby the said dendritic or hyperbranched macromolecule and said conventional resin is present in a weight ratio of 1:99 to 30:70, optionally in addition with at least one curing agent, catalyst, inhibitor or stabiliser in a moulded article to improve tenacity and/or critical stress intensity factor.

**16.** The use according to claim 15, wherein the said dendritic or hyperbranched macromolecule and the said conventional resin or compound is present in a weight ratio of 5:95 to 25:75.

**Patentansprüche**

**1.** Formkörper mit verbesserten physikalischen Eigenschaften, der durch Formen und Aushärten oder teilweises Aushärten einer Harzzusammensetzung erhalten wird, die mindestens zwei wärmehärtbare Harze und gegebenenfalls zusätzlich dazu mindestens ein Härtemittel, einen Katalysator, Inhibitor oder Stabilisator enthält, dadurch gekennzeichnet, dass mindestens eines der wärmehärtbaren Harze ein mindestens teilweise kettenterminiertes, dendritisches oder hyperverzweigtes Polyestermakromolekül mit mindestens einer primären oder sekundären reaktiven Stelle ist, dass mindestens eines ein herkömmliches wärmehärtbares Harz ist, ausgewählt aus der Gruppe bestehend aus einem Polyepoxid, einem Kautschuk-modifizierten Polyepoxid, einem gesättigten oder ungesättigten Polyester, einem hydroxyfunktionalisierten, gesättigten oder ungesättigten Polyester, einem Polyamin oder einem Polyamid, einem Phenol-Formaldehydharz, einem Phenolaminharz, einem Polyimid oder Polyetherimid, einem Melamin-Formaldehydharz, einem Harnstoff-Formaldehydharz, einem Polyurethan mit einer der funktionellen Gruppen -OH, -COOH oder -NCO, und dass das dendritische oder hyperverzweigte Makromolekül und das herkömmliche Harz in einem Gewichtsverhältnis von 1:99 bis 30:70 vorliegen.

**2.** Formkörper gemäss Anspruch 1, dadurch gekennzeichnet, dass die reaktive Stelle eine primäre oder sekundäre Epoxygruppe ist.

**3.** Formkörper gemäss Anspruch 1, dadurch gekennzeichnet, dass die reaktive Stelle eine primäre oder sekundäre Aminogruppe ist.

4. Formkörper gemäss Anspruch 1, dadurch gekennzeichnet, dass die reaktive Stelle eine primäre oder sekundäre Alkenylgruppe ist.

5. Formkörper gemäss Anspruch 1, dadurch gekennzeichnet, dass die reaktive Stelle eine primäre oder sekundäre Anhydridgruppe ist.

6. Formkörper gemäss einem der Ansprüche 1 bis 5, dadurch gekennzeichnet, dass er zusätzlich zu der Harzzusammensetzung mindestens einen Füllstoff, ein Pigment oder ein Gleitmittel umfasst.

7. Formkörper gemäss einem der Ansprüche 1 bis 6, dadurch gekennzeichnet, dass er Fasern als Verstärkungsmaterial umfasst.

8. Formkörper gemäss Anspruch 7, dadurch gekennzeichnet, dass die Fasern ausgewählt sind aus der Gruppe bestehend aus Glasfasern, Kohlenstoffasern, Aramidfasern und organischen Fasern, wie Cellulose.

9. Formkörper gemäss einem der Ansprüche 1 bis 8, dadurch gekennzeichnet, dass der Formkörper erhalten wird mit einem kontinuierlichen Düsenformungsverfahren, wie Spritzgiessen, Formpressen, Karusselpressen, Gravitationsformen, Blasformen oder Extrusion.

10. Formkörper gemäss einem der Ansprüche 1 bis 8, dadurch gekennzeichnet, dass der Formkörper erhalten wird mit einer Verarbeitungstechnik, ausgewählt aus der Gruppe bestehend aus Harzeintauchen oder -infusion, Kompressionstransfer, Vakuumformen, Transferpressen, Spritzgiessen, gasunterstütztem Spritzgiessen, Strukturspritzgiessen, Fadenwickelverfahren, Extrusion, Karusselpressen, Gravitationsformen und Blasformen.

11. Formkörper gemäss einem der Ansprüche 1 bis 10, dadurch gekennzeichnet, dass der Formkörper ein sogenanntes Prepreg ist, das durch teilweises Aushärten einer Walze, einer Folie, einer Bahn, eines Gewebes, von Fäden oder Schnitten, die mit der wärmehärtbaren Harzzusammensetzung imprägniert sind, in einen sogenannten B-Zustand erhalten wird.

12. Formkörper gemäss einem der Ansprüche 1 bis 10, dadurch gekennzeichnet, dass der Formkörper ein Dekor- oder Industrielaminat ist.

13. Formkörper gemäss Anspruch 12, dadurch gekennzeichnet, dass das Laminat durch Aushärten mindestens eines Prepregs erhalten wird.

14. Formkörper gemäss einem der Ansprüche 1 bis 10, dadurch gekennzeichnet, dass der Formkörper ein halbfertiges oder fertiges Produkt ist, das ausgewählt ist aus der Gruppe bestehend aus Luftfahrtwaren und -artikeln, Schiffswaren und -artikeln, Chemikalien und chemischen Waren und Artikeln, Kfz-Waren und -Artikeln, Sportwaren und -artikeln, Freizeit- und Bedarfsgütern und -artikeln und elektrischen und elektronischen Waren und Artikeln.

15. Verwendung eines wenigstens teilweise kettenterminierten dendritischen oder hyperverzweigten Polyestermakromoleküls mit mindestens einer primären oder sekundären reaktiven Stelle zusammen mit wenigstens einem herkömmlichen wärmehärtbaren Harz, ausgewählt aus der Gruppe bestehend aus einem Polyepoxid, einem Kautschuk-modifizierten Polyepoxid, einem gesättigten oder ungesättigten Polyester, einem hydroxyfunktionalisierten gesättigten oder ungesättigten Polyester, einem Polyamin oder einem Polyamid, einem Phenol-Formaldehydharz, einem Phenolaminharz, einem Polyimid oder Polyetherimid, einem Melamin-Formaldehydharz, einem Harnstoff-Formaldehydharz, einem Polyurethan mit einer der funktionellen Gruppen -OH, -COOH oder -NCO, wobei das dendritische oder hyperverzweigte Makromolekül und das herkömmliche Harz in einem Gewichtsverhältnis von 1:99 bis 30:70 vorliegen, gegebenenfalls zusätzlich mit wenigstens einem Härtemittel, Katalysator, Inhibitor oder Stabilisator in einem Formkörper zur Verbesserung der Festigkeit und/oder des kritischen Spannungsintensitätsfaktors.

16. Verwendung gemäss Anspruch 15, wobei das dendritische oder hyperverzweigte Makromolekül und das herkömmliche Harz oder die Verbindung in einem Verhältnis von 5:95 bis 25:75 vorliegen.

## Revendications

1. Article moulé présentant des propriétés physiques améliorées, obtenu par moulage et durcissement complet ou partiel d'une composition de résine comprenant au moins deux résines thermodurcissables et éventuellement en plus au moins un agent de durcissement, catalyseur, inhibiteur et/ou stabilisateur, caractérisé par le fait qu'au moins une desdites résines thermodurcissables est une macromolécule de type polyester dendritique ou hyperramifié portant sur au moins une partie de ses extrémités un agent de terminaison de chaîne et ayant au moins un site réactif primaire ou secondaire, qu'au moins l'une des résines est une résine thermodurcissable usuelle choisie dans le groupe formé par un polyépoxyde, un polyépoxyde modifié par du caoutchouc, un polyester saturé ou insaturé, un polyester saturé ou insaturé à fonctions hydroxy, une polyamine ou un polyamide, une résine phénol-formaldéhyde, une résine amino-phénolique, un polyimide ou poly(éther imide), une résine mélamine-formaldéhyde, une résine urée-formaldéhyde, un polyuréthanne portant des groupes fonctionnels -OH, -COOH ou -NCO, et que ladite macromolécule dendritique ou hyperramifiée et ladite résine usuelle sont présentes en un rapport en poids compris entre 1/99 et 30/70.

2. Article moulé selon la revendication 1, caractérisé par le fait que ledit site réactif est un groupe époxyde primaire ou secondaire.

3. Article moulé selon la revendication 1, caractérisé par le fait que ledit site réactif est un groupe amino primaire ou secondaire.

4. Article moulé selon la revendication 1, caractérisé par le fait que ledit site réactif est un groupe alcényle primaire ou secondaire.

5. Article moulé selon la revendication 1, caractérisé par le fait que ledit site réactif est un groupe anhydride primaire ou secondaire.

6. Article moulé selon l'une quelconque des revendications 1 à 5, caractérisé par le fait qu'il contient, en plus de ladite composition de résine, au moins une charge, un pigment et/ou un agent lubrifiant.

7. Article moulé selon l'une quelconque des revendications 1 à 6, caractérisé par le fait qu'il contient des fibres en tant que matériau de renforcement.

8. Article moulé selon la revendication 7, caractérisé par le fait que lesdites fibres sont choisies dans le groupe formé par les fibres de verre, les fibres de carbone, les fibres aramide et les fibres organiques telles que la cellulose.

9. Article moulé selon l'une quelconque des revendications 1 à 8, caractérisé par le fait que l'on obtient ledit article par un procédé de formage en continu à partir d'une filière tel que le moulage par injection, le moulage par compression, le moulage par rotation, le moulage par gravité, l'extrusion-soufflage ou l'extrusion.

10. Article moulé selon l'une quelconque des revendications 1 à 8, caractérisé par le fait que l'on obtient ledit article au moyen d'une technique de mise en oeuvre choisie dans le groupe formé par l'immersion dans une résine ou imprégnation par une résine, la compression-transfert, le moulage sous vide, le moulage-transfert, le moulage par injection, le moulage par injection assisté par un gaz, le moulage par injection structurel, l'enroulement de filament, l'extrusion, le moulage par rotation, le moulage par gravité et l'extrusion-soufflage.

11. Article moulé selon l'une quelconque des revendications 1 à 10, caractérisé par le fait que ledit article est ce que l'on appelle un préimprégné obtenu par durcissement partiel, jusqu'à ce que l'on appelle le stade B, d'un rouleau, d'une feuille, d'un filet, d'un tissu, de fils ou de fibres courtes, imprégnés par la composition de résine thermodurcissable.

12. Article moulé selon l'une quelconque des revendications 1 à 10, caractérisé par le fait que ledit article est un stratifié décoratif ou industriel.

13. Article moulé selon la revendication 12, caractérisé par le fait que ledit stratifié est obtenu par durcissement d'au moins un préimprégné.

14. Article moulé selon l'une quelconque des revendications 1 à 10, caractérisé par le fait que ledit article est un produit

semi-fini ou fini choisi dans le groupe formé par les produits et articles pour l'industrie aéronautique, les produits chimiques, les produits et articles pour l'industrie nautique, les produits et articles pour l'industrie chimique, les produits et articles pour l'industrie automobile, les produits et articles de sport, les produits et articles de loisir et de confort, et les produits et articles électriques et électroniques.

**15.** Utilisation d'une macromolécule de type polyester dendritique ou hyperramifié portant sur au moins une partie de ses extrémités un agent de terminaison de chaîne et ayant au moins un site réactif primaire ou secondaire, en association avec au moins une résine thermodurcissable usuelle, choisie dans le groupe formé par un polyépoxyde, un polyépoxyde modifié par du caoutchouc, un polyester saturé ou insaturé, un polyester saturé ou insaturé à fonctions hydroxy, une polyamine ou un polyamide, une résine phénol-formaldéhyde, une résine amino-phénolique, un polyimide ou poly(éther imide), une résine mélamine-formaldéhyde, une résine urée-formaldéhyde, un polyuréthanne portant des groupes fonctionnels -OH, -COOH ou -NCO, ladite macromolécule dendritique ou hyperramifiée et ladite résine usuelle étant présentes en un rapport en poids compris entre 1/99 et 30/70, éventuellement en présence d'au moins un agent de durcissement, catalyseur, inhibiteur et/ou stabilisateur dans un article moulé afin d'améliorer la ténacité et/ou le facteur d'intensité de contrainte critique de celui-ci.

**16.** Utilisation selon la revendication 15, dans laquelle ladite maromolécule dendritique ou hyperramifiée et ladite résine usuelle sont présentes en un rapport en poids compris entre 5/95 et 25/75.